(19) Europäisches Patentamt / European Patent Office / Office européen des brevets

(11) **EP 3 529 991 B1**

(12) **FASCICULE DE BREVET EUROPEEN**

(45) Date de publication et mention de la délivrance du brevet:
**08.07.2020   Bulletin 2020/28**

(21) Numéro de dépôt: **17765461.3**

(22) Date de dépôt: **14.09.2017**

(51) Int Cl.:
*H04N 21/41* (2011.01)   *H03J 7/18* (2006.01)
*H04H 60/51* (2008.01)   *H04N 5/44* (2011.01)
*H04N 5/455* (2006.01)   *H04N 5/50* (2006.01)
*H04N 21/426* (2011.01)   *H04N 21/438* (2011.01)

(86) Numéro de dépôt international:
**PCT/EP2017/073197**

(87) Numéro de publication internationale:
**WO 2018/072938 (26.04.2018 Gazette 2018/17)**

(54) **SYSTEME ET PROCEDE DE PRODUCTION AUTOMATIQUE D'UN PLAN DE SERVICES**

SYSTEM UND VERFAHREN ZUM AUTOMATISCHEN GENERIEREN EINEM DIENSTPLAN

SYSTEM AND METHOD FOR AUTOMATICALLY PRODUCING A SERVICE PLAN

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.10.2016   FR 1660097**

(43) Date de publication de la demande:
**28.08.2019   Bulletin 2019/35**

(73) Titulaire: **Sagemcom Broadband SAS**
**92500 Rueil-Malmaison (FR)**

(72) Inventeur: **DÉJARDIN, Romain**
**92500 Rueil Malmaison (FR)**

(74) Mandataire: **Cabinet Camus Lebkiri**
**25 rue de Maubeuge**
**75009 Paris (FR)**

(56) Documents cités:
**EP-A1- 2 770 437      EP-A2- 1 838 096**
**WO-A1-2009/018766      JP-A- 2003 333 441**

**Description**

**Domaine de l'invention**

L'invention a pour objet un procédé de production automatique d'un plan de services. Le domaine de l'invention est celui des boîtiers décodeur de télévision aussi appelés des « set top box » ou des simplement des « box ». Un tel boîtier est un dispositif intermédiaire entre une diffusion de programme et une restitution dudit programme sous forme d'une vidéo, c'est-à-dire entre le diffuseur et l'écran. Dans la pratique il peut être intégré au téléviseur.
Plus particulièrement le domaine de l'invention est celui de la configuration automatique de tels dispositifs.

**Etat de la technique**

Le problème décrit ici correspond au cas d'un dispositif de réception de signaux de télé/radiodiffusion numérique à voies multiples, sans connaissance a priori de la répartition des fréquences et des services qui y sont associés. Dans ce contexte, il est habituel de tester, à l'aveugle, chaque sous-bande de la bande de fréquence utilisable disponible afin de détecter la présence d'un signal offrant des services de télé/radiodiffusion. Une fois un signal détecté et ses paramètres de couche physique identifiés, il convient ensuite de récupérer les informations du flux binaire donnant les services offerts par le canal. Ces détection et récupérations séquentielle permet d'obtenir un plan de services global (i.e. la liste des services) associé à chaque canal fréquentiel découvert lors du balayage.
Le balayage s'effectue donc service par service ce qui prend énormément de temps et donne l'impression d'un dispositif de réception de signaux bloqué. L'attente dure plusieurs dizaines de minutes. La seule solution existante et l'affichage d'une barre de patience pour montrer à un utilisateur que l'appareil est en train d'effectuer une tâche longue.
Ce problème est d'autant plus important que ce balayage doit être effectué à chaque apparition d'un nouveau service.

**Exposé de l'invention**

L'invention vise à remédier à tout ou partie des inconvénients de l'état de la technique identifiés ci-dessus, et notamment à proposer des moyens pour permettre d'améliorer l'expérience utilisateur.
Afin de réduire le temps de balayage, l'invention enseigne un procédé qui :

- dissocie les étapes de découverte des canaux fréquentiels et les étapes de récupération des services associés, et
- exécute la découverte et la récupération en parallèle.

Le but est de pouvoir accélérer le balayage complet et le renseignement du plan des services.
Cette approche exploite au maximum les récepteurs (aussi appelé « front-end ») que comporte les dispositifs boîtier décodeur.
Dans ce dessein, un aspect de l'invention se rapporte à un procédé de production automatique d'un plan de services d'un dispositif boitier décodeur, ledit dispositif boitier décodeur comportant une pluralité de récepteurs et enregistrant le plan de services produit dans une mémoire de configuration après la mise en oeuvre de la méthode de la revendication 1 annexée.
D'autres aspects sont définis dans les revendications dépendantes 2-8.
L'invention a également pour objet un dispositif de production automatique d'un plan de services ledit dispositif comportant une pluralité de récepteurs et enregistrant le plan de services produit dans une mémoire de configuration, le dispositif étant défini par la revendication 9 annexée.
L'invention a également pour objet un dispositif mémoire non transitoire selon la revendication 11 annexée.
L'invention a également pour objet un produit programme d'ordinateur selon la revendication 12 annexée.

**Brève description des figures**

D'autres caractéristiques et avantages de l'invention ressortiront à la lecture de la description qui suit, en référence aux figures annexées, qui illustrent :

- la figure 1, une représentation schématique de moyens matériels permettant la mise en œuvre du procédé selon l'invention ;
- la figure 2, une illustration d'étapes du procédé selon l'invention.

Pour plus de clarté, les éléments identiques ou similaires sont repérés par des signes de référence identiques sur l'ensemble des figures.

L'invention sera mieux comprise la lecture de la description qui suit et à l'examen des figures qui l'accompagnent. Celles-ci sont présentées à titre indicatif

Le document JP 2003333441 A présente une méthode et un dispositif permettant de réduire le temps nécessaire pour acquérir des informations sur la sélection des chaînes et des informations sur les programmes. Une bande de fréquences est divisée en une pluralité de sous-bandes qui sont toutes balayées en parallèle. Les documents EP 1838096 A2 et WO 2009/018766 A1 présentent des solutions similaires.

**Description détaillée**

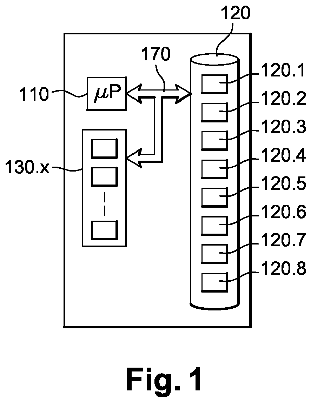

La figure 1 montre un dispositif boîtier 100 décodeur. Le boîtier 100 décodeur comporte :

- un microprocesseur 110. Il s'agit de moyens de traitement représentés de manière simplifié. Il est possible qu'un boîtier décodeur comporte plusieurs microprocesseur, avec par exemple un microprocesseur dédié au traitement d'image (décompression principalement);
- des moyens de stockage 120, par exemple un disque dur qu'il soir local ou distant, qu'il soit simple ou en grille (par exemple RAID), ou une puce mémoire;
- une pluralité de récepteurs 130.X. Un récepteur est, par exemple, un ensemble de moyens adaptés pour traiter un signal analogique reçu via une antenne. Pour la description on considère que le boîtier décodeur 100 comporte K récepteur et que K est supérieure ou égale à deux.

Des moyens adaptés pour traiter un signal analogique sont, par exemple, un circuit démodulateur produisant une trame de bits, le circuit démodulateur étant suivi d'un circuit de décodage pour le traitement de la trame. Un tel circuit de décodage est, par exemple, un décodeur MPEG. Dans le domaine un tel récepteur est appelé un Front-End. On parle aussi de tuner.

La figure 1 montre que le microprocesseur 110 du boîtier décodeur, les moyens 120 de stockage du boîtier décodeur et les récepteurs 130.X sont interconnectés par un bus 170.

La figure 1 montre que les moyens 120 de stockage comportent plusieurs zones. La figure 1 montre que les moyens 120 de stockage comportent :

- une zone 120.1 comportant des codes instructions pour la mise en œuvre du procédé selon l'invention ;
- une zone 120.2 comportant une description d'une bande de fréquences à explorer ;
- une zone 120.3 prochaine exploration comportant une valeur de la prochaine fréquence à explorer ;
- une zone 120.4 comportant une liste de fréquences à analyser. Une liste est une structure en mémoire qui permet d'enregistrer une pluralité de données de même nature. La structure de la liste elle-même n'est pas importante, ici ce qui importe c'est qu'elle permet d'effectuer un tampon entre un processus de remplissage de la liste, et un processus de vidage de la liste. Le remplissage est le résultat d'une exploration de la bande de fréquences. Le vidage est le résultat d'une analyse des fréquences détectées.
- une zone 120.5 comportant une valeur de la prochaine fréquence à analyser ;
- une zone 120.6 comportant une table de services découverts. Une table est une structure en mémoire. Celle-ci sert de structure intermédiaire entre le procédé selon l'invention un dispositif boîtier décodeur mettant en œuvre ledit procédé. Sa structure n'est pas importante. Une telle table est cependant agencée pour être compatible avec les métadonnées transportées par des flux audio/vidéo de type MPEG. Ces métadonnées sont des informations spécifiques à un programme. En particulier une telle table permet d'enregistrer des données correspondant à une table d'association de program (aussi appelée table PAT) telle que définie par la norme MPEG. Cette table n'est qu'un exemple. Les principes de l'invention reste valable avec d'autres structures de tables de services ;
- une zone 120.7 comportant des valeurs pour des paramètres de configurations du procédé selon l'invention, par exemple une valeur pour un délai d'attente (on parle aussi de timeout) à partir duquel on considère qu'une exploration n'aboutira pas, c'est-à-dire qu'il n'y a pas de service sur la fréquence explorée ;
- une zone 120.8 comportant le plan de services du dispositif boîtier décodeur.

Lorsque l'on prête une action à un dispositif celle-ci est en fait effectuée par un microprocesseur du dispositif commandé par des codes instructions enregistrés dans une mémoire du dispositif. Si l'on prête une action à une application, celle-ci est en fait effectuée par un microprocesseur du dispositif dans une mémoire duquel les codes instructions correspondant à l'application sont enregistrés. Lorsqu'un dispositif, ou une application émet ou reçoit un message, ce message est émis ou reçu via une interface de communication dudit dispositif ou de la dite application.

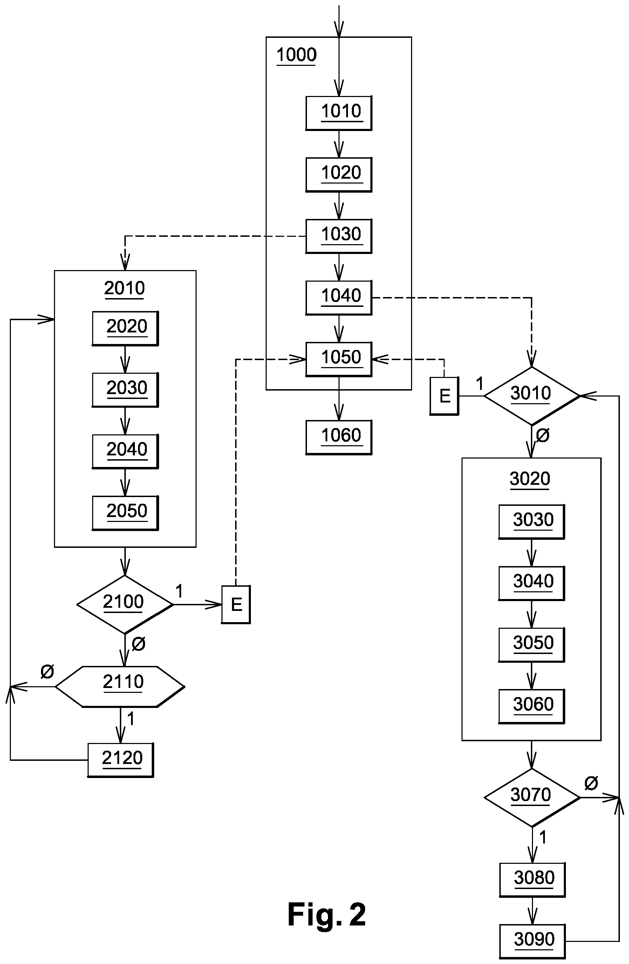

La figure 2 montre une étape 1000 préliminaire dans laquelle un utilisateur du boîtier décodeur 100 utilise une interface homme machine du boîtier décodeur 100 pour déclencher un balayage de fréquence. Dans l'étape 1000 préliminaire le boîtier décodeur configure le procédé selon l'invention et effectuant les sous étapes suivantes :

- répartition 1010 des K récepteurs en deux groupes :

  - un premier groupe comportant N récepteurs,
  - un deuxième groupe comportant M récepteurs,

- écriture 1020 de la prochaine fréquence à explorer, cette valeur étant lue dans la zone 120.2 de description de la bande de fréquences à explorer. En particulier on utilise la borne inférieure de la bande de fréquences pour initialiser la valeur de la prochaine fréquence à explorer.
- création 1030 d'instances de tâche d'exploration, une instance pour chaque récepteur du premier groupe,
- création 1040 d'instances de tâche d'analyse, une instance pour chaque récepteur du deuxième groupe.
- attente 1050 que toutes les instances de tâches créées aient fini leur exécution.

Dans la répartition en deux groupes, un récepteur ne pouvant appartenir qu'à un et un seul groupe, on a :

$$N + M <= K.$$

Dans la pratique chaque récepteur est associé un identifiant unique pour le boîtier décodeur 100, la répartition étant alors la production de deux listes d'identifiants en mémoire de travail.

La création d'une instance de tâche comprend classiquement les étapes suivantes :

- allocation de ressources d'exécution, c'est-à-dire au moins une zone mémoire et du temps de calcul sur le microprocesseur 110, le tout formant un contexte d'exécution ;
- attribution au contexte d'un point d'entrée pour un programme à mettre en œuvre ;
- soumission du contexte à un moteur de cadencement multitâche.

Ainsi à la fin de l'étape 1040 le boîtier décodeur héberge N + M tâches actives s'exécutant en parallèle.

La figure 2 montre une étape 2010 d'acquisition de la prochaine fréquence à explorer. Cette étape est la première étape d'une tâche d'exploration de fréquence. L'étape 2010 d'acquisition de la prochaine fréquence à explorer comporte les sous étapes suivante :

- prise 2020 d'un premier sémaphore,
- lecture 2030 du contenu de la zone prochaine exploration et affectation de la valeur lue à une variable locale à l'instance de la tâche, cette variable étant la fréquence courante de l'instance de la tâche,
- mise à jour 2040 du contenu de la zone prochaine exploration en fonction de la fréquence courante ;
- libération 2050 du premier sémaphore ;

L'utilisation d'un premier sémaphore permet d'assurer la synchronisation paisible des tâches d'explorations. Cela Garantit que deux tâche d'exploration concurrentes :

- n'explorent pas la même fréquence ;
- ne mettent pas à jour la zone prochaine exploration en même temps.

La mise à jour du contenu de la zone prochaine exploration se fait, par exemple, en incrémentant la valeur courante d'un pas prédéterminé. Ce pas est tel que deux tâches d'exploration ayant chacune leur valeur courante de fréquence ne se chevauchent pas. Ce pas peut aussi être arbitraire.

Si la norme de diffusion précise la largeur, ou bande passante du signal utile, par exemple en DVBT, alors le pas prédéterminé est en fait déterminée en utilisant la fréquence actuelle à laquelle on ajoute la moitié de la bande passante du signal utile. Sinon, la bande passante est déterminée par itération d'essais successifs (par exemple en DVBS) puis corrigée après l'accrochage du FE (qui autorise un recouvrement de plusieurs MHz) pour déterminer la bande passante du signal utile.

L'étape 2010 d'acquisition de la prochaine fréquence à explorer est suivie d'une étape 2100 d'évaluation d'une condition d'arrêt de la tâche d'exploration. Si cette condition est validée, alors la tâche s'arrête. Sinon on passe à une étape 2110 d'exploration de la fréquence courante. La condition d'arrêt d'une tâche d'exploration est vraie, c'est-à-dire validée, si la valeur de fréquence courante est supérieure à la borne supérieure de la bande de fréquence à explorer. Cette borne supérieure est connue par lecture du contenu de la zone 120.2 de description de la bande de fréquence à explorer.

Dans l'étape 2110 on cherche à détecter si la fréquence explorée comporte un service. Il y a au moins de manière de procéder :

- est-ce que la fréquence porte de la puissance, ou
- est-ce qu'une tentative de décodage produit une trame valide ?

Quel que soit le mode de détection retenu, il est tenté au maximum pendant un délai d'attente de détection, ou timeout de détection. Ce délai d'attente vaut classiquement deux fois le temps qu'il faut pour que la détection conclue à la présence d'un service en cas de présence d'un service. Classiquement ce délai d'attente vaut 400ms. Si aucun service n'est détecté, alors on passe à l'étape 2010 d'acquisition de la prochaine fréquence à explorer. Sinon on passe à une étape 2120 d'insertion d'une fréquence à analyser dans la liste 120.4 des fréquences à analyser. A la fin de l'étape 2120 d'insertion d'une fréquence à analyser on passe l'étape 2010 d'acquisition de la prochaine fréquence à explorer.

Dans l'étape d'insertion d'une fréquence à analyser l'instance de tâche d'analyse crée un enregistrement de fréquence à analyser comportant au moins la valeur de la fréquence ayant permis la détection. Cette fréquence est la fréquence centrale du canal détecté.

Les tâches d'exploration sont donc des productrices d'enregistrement de fréquences à analyser. Un enregistrement de fréquence à analyser est une structure en mémoire permettant la description de la fréquence à analyser. Ces enregistrements sont ensuite consommés par des tâches d'analyse.

La figure 2 montre une étape 3010 d'évaluation d'une condition d'arrêt d'une tâche d'analyse. Cette étape est la première étape d'une tâche d'analyse de fréquence. Une telle condition est que la liste des fréquences à analyser est vide et toutes les tâches d'exploration sont arrêtées. Cette deuxième condition peut aussi être : la valeur de la prochaine fréquence à explorer est supérieure à la borne supérieure de la bande de fréquence à explorer. Si cette condition est validée alors la tâche se termine. Sinon on passe à une étape 3020 d'acquisition de la prochaine fréquence à analyser.

La zone comportant la prochaine fréquence à analyser est protégée par un deuxième sémaphore. Cette zone peut contenir un identifiant d'une fréquence dans la liste des fréquences à analyser, ou un pointeur. Cette zone peut également n'être qu'un sémaphore qui protège un appel à une fonction de récupération d'une fréquence dans la liste des fréquences à analyser. Ainsi cette fonction de récupération n'est disponible que pour une instance de tâche à la fois, ce qui garantit une bonne gestion de la concurrence pour l'analyse des fréquences. Ainsi on dispose de plusieurs modes de réalisation pour obtenir qu'une même fréquence ne soit pas analysée plusieurs fois.

Ainsi l'étape 3020 comporte les sous étape suivantes :

- prise 3030 d'un deuxième sémaphore,
- assignation 3040 d'une fréquence à analyser courante de l'instance de la tâche par la valeur de la prochaine fréquence à analyser,
- mise à jour 3050 de la valeur de la prochaine fréquence à analyser en fonction de la valeur de la fréquence à analyser courante,
- libération 3060 du deuxième sémaphore.

Dans une variant on n'utilise qu'un seul sémaphore, c'est-à-dire le même sémaphore pour les deux tâches.

Dans une étape 3070 suivant l'étape 3020 d'acquisition de la prochaine fréquence à explorer, s'il n'y a aucune fréquence, c'est-à-dire si la liste des fréquences à explorer est vide car les tâches d'explorations n'en trouvent pas, alors on passe à l'étape 3010 d'évaluation d'une condition d'arrêt de la tâche d'analyse. Sinon, s'il y a une fréquence à analyse on passe à une étape 3080 d'analyse de la fréquence. Une telle étape d'analyse revient à laisse le décodeur faire son travail, pour la fréquence courante, comme dans un balayage classique. A la fin de l'analyse on a donc produit des données qui permettent la mise à jour d'une table de service. C'est-à-dire la création, dans une étape 3090, d'un nouvel enregistrement dans la zone 120.6 table des services découverts. A la fin de l'étape 3090 de mise à jour on passe à l'étape 3010 d'évaluation d'une condition d'arrêt d'une tâche d'analyse.

Avec une autre formulation, dans l'invention, une tâche d'analyse reste active tant qu'une nouvelle fréquence à explorer est susceptible d'être ajoutée à la liste des fréquences à analyser. La condition d'arrêt d'une tâche d'analyse est donc double :

- la liste des fréquences à analyser est vide, et
- les tâches d'exploration sont toutes arrêtées.

De l'étape 1050, lorsque toutes les tâches selon l'invention sont terminées, on passe à une étape 1060 de mise à disposition de la table des services découverts produites au boîtier décodeur qui l'utilise pour mettre à jour une mémoire de configuration qui au pilotage dudit boîtier. En particulier une telle mémoire de configuration sert à la navigation parmi les services, c'est-à-dire les chaînes de télévision.

Avec l'invention on arrive à alimenter cette mémoire de configuration dix fois plus vite qu'avant l'invention. Le principe de l'invention est donc de découper le processus de découverte en deux étapes :

- une étape d'exploration pour détecter la présence d'un service,
- une étape d'analyse pour analyser les services.

De plus l'invention exploite au maximum les capacités du boîtier décodeur en menant en parallèle ces étapes.

Dans une variante de l'invention on utilise le deuxième sémaphore dans les tâches d'exploration pour protéger les accès à la liste des taches à analyser.

Dans une variant de l'invention dès que l'évaluation d'une condition d'une condition d'arrêt d'une tâche d'exploration est vraie, alors on change le récepteur correspondant de groupe et on créer une nouvelle instance de tâche d'analyse avec ce récepteur. C'est-à-dire en fait dès que l'exploration est terminée.

Dans une variant de l'invention on optimise les valeurs de N et de M. Des mises en œuvres simples sont :

-

$$N = M = K \, / \, 2,$$

ou

-

$$N = 1 \, / \, 3 \, * \, K, \, M = K - N,$$

en partant du principe que l'exploration est plus rapide que l'analyse.

Dans une variante plus complexe on optimise N et M avec la formule suivante :

$$M = K - N,$$

et

$$N = K * \frac{(L * tE + P * tO)}{2 * L * tE + L * tA + P * tO}$$

avec :

L : le nombre estimé de fréquences porteuses de services
P : le nombre estimé de fréquences non porteuses de services
tE : le temps d'exploration d'une fréquence porteuse de services
t0 : le temps d'exploration d'une fréquence non porteuse de services
tA : le temps d'analyse d'une fréquence.

Tous les temps sont exprimés dans la même unité, par exemple la milliseconde.

Cette formule est basée sur une estimation du nombre de fréquences porteuses de services dans la bande de fréquences à explorer ainsi que du nombre de fréquences non porteuses de services. La mise en œuvre de cette formule maximise le nombre de récepteurs utilisés pour l'analyse. Cette maximisation essaye d'obtenir que les instances de tâches d'exploration et d'analyse se terminent au même moment à la durée d'une tâche d'analyse près.

On constate dans la formule un terme L * (tE + tA) dans le diviseur car l'analyse d'une fréquence refait toutes les étapes d'un balayage classique, ce qui inclut l'accrochage du canal pour une durée L * tE.

L'utilisation de cette approche maximise les performances du procédé selon l'invention.

Avec cette approche on arrive donc à N différent de M, le valeurs de N et M étant optimisées en partant du constat que le temps d'exploration maximum vaut, avec les définitions précédemment utilisée:

$$max \, ( \, ((L*tE) + (P*tO)) \, / \, N \, ; \, L*(tE + tA) \, / \, M \, )$$

Evidemment l'invention reste valable si on choisit des valeurs arbitraires de N et M ou des valeurs dépendant d'autres considérations.

**Revendications**

1. Procédé de production automatique d'un plan de services d'un dispositif boitier décodeur (100), ledit dispositif boitier décodeur comportant une pluralité de récepteurs (130.X) et enregistrant le plan de services produit dans une mémoire de configuration après la mise en œuvre des étapes suivantes :

   - répartition (1020) des récepteurs dans deux groupes, chaque groupe étant dédié à une tâche :

      - un premier groupe de récepteurs est dédié à une tâche d'exploration d'une bande de fréquence à explorer, bande dont on connait la borne inférieure et la borne supérieure, une instance de tâche d'exploration alimente une liste de fréquences porteuses de services, les instances de tâches d'explorations se synchronisent (2010) via un premier sémaphore protégeant une valeur de prochaine fréquence à explorer, une instance de tâche d'exploration s'arrête si la valeur de prochaine fréquence à explorer est supérieure à la borne supérieure de la bande de fréquence à explorer;
      - un deuxième groupe de récepteurs est dédié à une tâche d'analyse des fréquences de la liste de fréquences porteuses de services, une instance de tâche d'analyse alimente une table de services, les instances de tâches d'analyse se synchronisent via un deuxième sémaphore protégeant un identifiant d'une prochaine fréquence à analyser, une instance de tâche d'analyse s'arrête si la liste de fréquences porteuses de services est vide et si la valeur de prochaine fréquence à explorer est supérieure à la borne supérieure de la bande de fréquence ;

      - création (1030, 1040) d'instances de tâches selon la répartition des récepteurs, chaque récepteur réparti étant associé à une tâche selon son groupe, les instances de tâches sont exécutées en parallèle ;
      - mise à disposition (1060) de la table des services produite pour la mise à jour de la mémoire de configuration.

2. Procédé de production automatique d'un plan de services selon la revendication 1, dans lequel une instance de tâche d'exploration comporte les étapes suivantes :

   - prise (2020) du premier sémaphore,
   - assignation (2030) d'une fréquence à explorer courante de l'instance de la tâche par la valeur de la prochaine fréquence à explorer,
   - mise à jour (2040) de la valeur de la prochaine fréquence à explorer en fonction de la valeur de la fréquence à explorer courante,
   - libération (2050) du premier sémaphore,
   - évaluation (2100) de la condition d'arrêt d'une tâche d'exploration,
   - exploration (2110) de la fréquence à explorer courante,

      - si la fréquence à explorer courante comporte un service alors mise à jour (2120) de la table des fréquences à analyser.

3. Procédé de production automatique d'un plan de services selon l'une des revendications précédentes, dans lequel une instance d'une tâche d'analyse comporte les étapes suivantes :

   - évaluation (3010) de la condition d'arrêt d'une tâche d'analyse,
   - prise (3030) du deuxième sémaphore,
   - assignation (3040) d'une fréquence à analyser courante de l'instance de la tâche par la valeur de la prochaine fréquence à analyser,
   - mise à jour (3050) de la valeur de la prochaine fréquence à analyser en fonction de la valeur de la fréquence à analyser courante,
   - libération (3060) du deuxième sémaphore,
   - si il y a une fréquence à analyser :

      - analyse (3080) de la fréquence à analyser courante,
      - mise à jour (3090) de la table des services.

4. Procédé de production automatique d'un plan de services selon l'une des revendications précédentes, dans lequel une fréquence explorée est considérée comme dépourvue de service si l'exploration dure plus d'un délai d'attente de fin d'exploration prédéterminée.

5. Procédé de production automatique d'un plan de services selon la revendication 4, dans lequel le délai d'attente de fin d'exploration vaut le double du temps permettant la détection d'un service en cas de présence d'un service.

6. Procédé de production automatique d'un plan de services selon l'une des revendications précédentes, dans lequel lorsque l'exploration est terminée, les récepteurs de premier groupe sont attribués au deuxième groupe et des instances de tâche d'analyse leur sont attribuées.

7. Procédé de production automatique d'un plan de services selon l'une des revendications précédentes, où, le dispositif boîtier décodeur comportant K récepteurs, le premier groupe comporte K / 2 récepteurs, le deuxième groupe comporte K / 2 récepteurs.

8. Procédé de production automatique d'un plan de services selon l'une des revendications 1 à 6, où, le dispositif boîtier décodeur comportant K récepteurs, le premier groupe comportant N récepteurs et le deuxième groupe comportant M récepteurs avec M = K - N, et

$$N = K * \frac{(L * tE + P * tO)}{2 * L * tE + L * tA + P * tO}$$

avec :

L : le nombre estimé de fréquences porteuses de services
P : le nombre estimé de fréquences non porteuses de services
tE : le temps d'exploration d'une fréquence porteuse de services
t0 : le temps d'exploration d'une fréquence non porteuse de services
tA : le temps d'analyse d'une fréquence.

9. Dispositif (100) de production automatique d'un plan de services ledit dispositif comportant une pluralité (130.X) de récepteurs et enregistrant le plan de services produit dans une mémoire de configuration, le dispositif de production comportant des moyens de traitements (110) et de mémorisation (120), lesdits moyens étant adaptés pour :

- répartir (1020) des récepteurs de la pluralité de récepteurs dans deux groupes, chaque groupe étant dédié à une tâche :

  - un premier groupe de récepteurs est dédié à une tâche d'exploration d'une bande de fréquence à explorer, bande dont on connaît la borne inférieurs et le borne supérieure, une instance de tâche d'exploration alimente une liste de fréquences porteuses de services, les instances de tâches d'explorations se synchronisent (2010) via un premier sémaphore protégeant une valeur de prochaine fréquence à explorer, une instance de tâche d'exploration s'arrête si la valeur de prochaine fréquence à explorer est supérieure à la borne supérieure de la bande de fréquence à explorer ;
  - un deuxième groupe de récepteurs est dédié à une tâche d'analyse des fréquences de la liste de fréquences porteuses de services, une instance de tâche d'analyse alimente une table de services, les instances de tâches d'analyse se synchronisent via un deuxième sémaphore protégeant un identifiant d'une prochaine fréquence à analyser, une instance de tâche d'analyse s'arrête si la liste de fréquences porteuse de services est vide et si la valeur de prochaine fréquence à explorer est supérieure à la borne supérieure de la bande de fréquence ;

- créer (1030 ; 1040) des instances de tâches selon la répartition des récepteurs, chaque récepteur réparti étant associé à une tâche selon son groupe, les instances de tâches sont exécutées en parallèle ;
- mettre à disposition (1060) de la table des services produite pour la mise à jour de la mémoire de configuration.

10. Dispositif selon la revendication 9, où il est un boîtier décodeur.

11. Dispositif mémoire non transitoire comportant des codes instruction pour la mise en œuvre d'un procédé selon l'une des revendications 1 à 8.

12. Produit programme d'ordinateur comprenant des instructions qui lorsque le programme est exécuté par un ordinateur, conduisent celui-ci à mettre en œuvre les étapes du procédé selon les revendications 1 à 8.

**Patentansprüche**

1. Automatisches Produktionsverfahren eines Dienstplans einer Dekodiererkasten-Vorrichtung (100), wobei die genannte Dekodiererkasten-Vorrichtung eine Vielzahl von Empfängern (130.X) umfasst und den Dienstplan abspeichert, der in einem Konfigurationsspeicher nach dem Umsetzen der folgenden Schritte erzeugt wird:

   - Verteilung (1020) der Empfänger in zwei Gruppen, wobei jede Gruppe für eine Aufgabe dediziert ist:

      - Eine erste Empfängergruppe ist für eine Untersuchungsaufgabe eines zu untersuchenden Frequenzbandes dediziert, wobei der untere Anschluss und der obere Anschluss des Bandes bekannt sind, eine unerledigte Untersuchungsaufgabe eine Liste von Dienstträger-Frequenzen versorgt, die unerledigten Untersuchungsaufgaben sich über einen ersten Semaphor synchronisieren (2010), der einen Wert einer nächsten zu untersuchenden Frequenz schützt, eine unerledigte Untersuchungsaufgabe endet, wenn der Wert der nächsten zu untersuchenden Frequenz höher ist als der obere Anschluss des zu untersuchenden Frequenzbandes;
      - Eine zweite Empfängergruppe ist für eine Analyseaufgabe der Frequenzen der Liste der Dienstträger-Frequenzen dediziert, eine unerledigte Analyseaufgabe versorgt eine Diensttabelle, die unerledigten Analyseaufgaben synchronisieren sich über einen zweiten Semaphor, der eine Kennung einer nächsten zu analysierenden Frequenz schützt, eine unerledigte Analyseaufgabe endet, wenn die Liste der zu untersuchenden Dienstträger-Frequenzen leer ist und wenn der Wert der nächsten zu untersuchenden Frequenz höher ist als der obere Anschluss des Frequenzbandes;

      - Anlegen (1030, 1040) von unerledigten Aufgaben gemäß der Verteilung der Empfänger, wobei jeder verteilte Empfänger einer Aufgabe gemäß seiner Gruppe zugeordnet ist, die unerledigten Aufgaben werden parallel ausgeführt;
      - Bereitstellen (1060) der Diensttabelle, die für die Aktualisierung des Konfigurationsspeichers erzeugt wird.

2. Automatisches Produktionsverfahren eines Dienstplans gemäß Anspruch 1, bei dem eine unerledigte Untersuchungsaufgabe die folgenden Schritte umfasst:

   - Abgriff (2020) des ersten Semaphors,
   - Zuordnung (2030) einer zu untersuchenden üblichen Frequenz der unerledigten Aufgaben durch den Wert der nächsten zu untersuchenden Frequenz,
   - Aktualisierung (2040) des Wertes der nächsten zu untersuchenden Frequenz in Abhängigkeit des Wertes der üblichen zu untersuchenden Frequenz,
   - Freigabe (2050) des ersten Semaphors,
   - Beurteilung (2100) der Beendigungsbedingung einer Untersuchungsaufgabe,
   - Untersuchung (2110) der üblichen zu untersuchenden Frequenz,

      - wenn die übliche zu untersuchende Frequenz einen dann aktualisierten Dienst (2120) der zu analysierenden Frequenztabelle aufweist.

3. Automatisches Produktionsverfahren eines Dienstplans gemäß einem der voranstehenden Ansprüche, bei dem eine unerledigte Aufgabe die folgenden Schritte umfasst:

   - Beurteilung (3010) der Beendigungsbedingung einer Analyseaufgabe,
   - Abgriff (3030) des zweiten Semaphors,
   - Zuordnung (3040) einer üblichen zu analysierenden Frequenz der unerledigten Aufgabe durch den Wert der nächsten zu analysierenden Frequenz,
   - Aktualisierung (3050) des Wertes der nächsten zu analysierenden Frequenz in Abhängigkeit des Wertes der zu analysierenden üblichen Frequenz,
   - Freigabe (3060) des zweiten Semaphors,

- Wenn eine zu analysierende Frequenz vorhanden ist:

- Analyse (3080) der üblichen zu analysierenden Frequenz,
- Aktualisierung (3090) der Diensttabelle.

4. Automatisches Produktionsverfahren eines Dienstplans gemäß einem der voranstehenden Ansprüche, bei dem eine untersuchte Frequenz als ohne Dienst gilt, wenn die Untersuchung länger als eine vorbestimmte Wartefrist des Untersuchungsendes dauert.

5. Automatisches Produktionsverfahren eines Dienstplans gemäß Anspruch 4, bei dem die Wartefrist des Untersuchungsendes das Doppelte der Zeit wert ist, die das Feststellen eines Dienstes für den Fall des Vorhandenseins eines Dienstes zulässt.

6. Automatisches Produktionsverfahren eines Dienstplans gemäß einem der voranstehenden Ansprüche, bei dem die Empfänger der ersten Gruppe der zweiten Gruppe zugeordnet sind und ihnen unerledigte Analyseaufgaben zugeordnet sind, wenn die Untersuchung abgeschlossen ist.

7. Automatisches Produktionsverfahren eines Dienstplans gemäß einem der voranstehenden Ansprüche, bei dem die genannte Dekodiererkasten-Vorrichtung K Empfänger umfasst, die erste Gruppe K / 2 Empfänger umfasst, die Gruppe K / 2 Empfänger umfasst.

8. Automatisches Produktionsverfahren eines Dienstplans gemäß einem der Ansprüche 1 bis 6, bei dem die Dekodiererkasten-Vorrichtung K Empfänger umfasst, die erste Gruppe N Empfänger umfasst und die zweite Gruppe M Empfänger umfasst, wobei M = K - N und.

$$N = K * \frac{(L * tE + P * t0)}{2 * L * tE + L * tA + P * t0}$$

wobei:

L: die geschätzte Anzahl von Dienstträger-Frequenzen ist
P: die geschätzte Anzahl von Nicht-Dienstträger-Frequenzen ist
tE: die Untersuchungszeit einer Dienstträger-Frequenz ist
t0: die Untersuchungszeit einer Nicht-Dienstträger-Frequenz ist
tA: die Analysezeit einer Frequenz ist.

9. Automatische Produktionsvorrichtung (100) eines Dienstplans, wobei die genannte Vorrichtung eine Vielzahl (130.X) von Empfängern umfasst und den Dienstplan abspeichert, der in einem Konfigurationsspeicher produziert ist, wobei die Produktionsvorrichtung Verarbeitungs- (110) und Speichermittel (120) umfasst, wobei die genannten Mittel geeignet sind zum:

- Verteilen (1020) der Empfänger der Vielzahl von Empfängern in zwei Gruppen, wobei jede Gruppe für eine Aufgabe dediziert ist:

- Eine erste Empfängergruppe ist für eine Untersuchungsaufgabe eines zu untersuchenden Frequenzbandes dediziert, wobei der unter Anschluss und der obere Anschluss des Bandes bekannt sind, eine unerledigte Untersuchungsaufgabe eine Liste von Dienstträger-Frequenzen versorgt, die unerledigten Untersuchungsaufgaben sich über einen ersten Semaphor synchronisieren (2010), der einen Wert einer nächsten zu untersuchenden Frequenz schützt, eine unerledigte Untersuchungsaufgabe endet, wenn der Wert der nächsten zu untersuchenden Frequenz höher ist als der obere Anschluss des zu untersuchenden Frequenzbandes;
- Eine zweite Empfängergruppe ist für eine Analyseaufgabe der Frequenzen der Liste der Dienstträger-Frequenzen dediziert, eine unerledigte Analyseaufgabe versorgt eine Diensttabelle, die unerledigten Analyseaufgaben synchronisieren sich über einen zweiten Semaphor, der eine Kennung einer nächsten zu analysierenden Frequenz schützt, eine unerledigte Analyseaufgabe endet, wenn die Liste der zu untersuchenden Dienstträger-Frequenzen leer ist und wenn der Wert der nächsten zu untersuchenden Frequenz höher ist als der obere Anschluss des Frequenzbandes;

- Anlegen (1030, 1040) von unerledigten Aufgaben gemäß der Verteilung der Empfänger, wobei jeder verteilte Empfänger einer Aufgabe gemäß seiner Gruppe zugeordnet ist, die unerledigten Aufgaben werden parallel ausgeführt;
- Bereitstellen (1060) der Diensttabelle, die für die Aktualisierung des Konfigurationsspeichers erzeugt wird.

10. Vorrichtung gemäß Anspruch 9, bei der sie ein Dekodiererkasten ist.

11. Nicht transiente Speichervorrichtung, umfassend Anweisungscodes für die Umsetzung eines Verfahrens gemäß einem der Ansprüche 1 bis 8.

12. Computerprogramm-Produkt, umfassend Anweisungen, die dieses dazu veranlassen, die Schritte des Verfahren gemäß den Ansprüchen 1 bis 8 durchzuführen, wenn das Programm durch einen Computer ausgeführt ist.

**Claims**

1. Method for automatically producing a service plan of a decoder box device (100), said decoder box device including a plurality of receivers (130.X) and recording the service plan produced in a configuration memory after implementation of the following steps:

   - distributing (1020) of the receivers into two groups, with each group being dedicated to a task:

      - a first group of receivers is dedicated to a task of exploring a frequency band to be explored, a band of which the lower limit and the upper limit are known, an instance of an exploration task supplies a list of frequencies carrying services, the exploration tasks instances are synchronised (2010) via a first semaphore protecting a value of the next frequency to be explored, an exploration task instance stops if the value of the next frequency to be explored is greater than the upper limit of the frequency band to be explored;
      - a second group of receivers is dedicated to an analysis task of the frequencies of the list of frequencies carrying services, an analysis task instance supplies a table of services, the analysis task instances are synchronised via a second semaphore protecting an identifier of a next frequency to be analysed, an analysis task instance stops if the list of frequencies carrying services is empty and if the value of the next frequency to be explored is greater than the upper limit of the frequency band;

   - creating (1030, 1040) of task instances according to the distribution of the receivers, with each receiver distributed being associated with a task according to the group thereof, the task instances are executed in parallel;
   - making available (1060) of the table of services produced for the updating of the configuration memory.

2. Method for automatically producing a service plan according to claim 1, wherein an exploration task instance includes the following exploration tasks:

   - taking (2020) of the first semaphore,
   - assigning (2030) of a current frequency to be explored of the task instance by the value of the next frequency to be explored,
   - updating (2040) of the value of the next frequency to be explored according to the value of the current frequency to be explored,
   - releasing (2050) of the first semaphore,
   - evaluating (2100) of the stop condition of an exploration task,
   - exploring (2110) the current frequency to be explored,
   - if the current frequency to be explored includes a service then updating (2120) of the table of the frequencies to be analysed.

3. Method for automatically producing a service plan according to one of the preceding claims, wherein an analysis task instance includes the following steps:

   - evaluating (3010) the stop condition of an analysis task,

- taking (3030) of the second semaphore,
- assigning (3040) of a current frequency to be analysed of the task instance by the value of the next frequency to be analysed,
- updating (3050) of the value of the next frequency to be analysed according to the value of the current frequency to be analysed,
- releasing (3060) of the second semaphore,
- if there is a frequency to be analysed:

    - analysing (3080) of the current frequency to be analysed,
    - updating (3090) of the table of services.

4.  Method for automatically producing a service plan according to one of the preceding claims, wherein an explored frequency is considered as devoid of service if the exploration lasts for more than a predetermined exploration end waiting time.

5.  Method for automatically producing a service plan according to claim 4, wherein the exploration end waiting time is double the time allowing for the detection of a service in case of the presence of a service.

6.  Method for automatically producing a service plan according to one of the preceding claims, wherein when the exploration is complete, the receivers of the first group are attributed to the second group and analysis task instances are attributed to them.

7.  Method for automatically producing a service plan according to one of the preceding claims, wherein, the decoder box system including K receivers, the first group includes K / 2 receivers, the second group includes K / 2 receivers.

8.  Method for automatically producing a service plan according to one of claims 1 to 6, where, the decoder box system including K receivers, the first group including N receivers and the second group including M receivers with M = K - N, and

$$N = K * \frac{(L * tE + P * tO)}{2 * L * tE + L * tA + P * tO}$$

with:

    L: the estimated number of frequencies carrying services
    P: the estimated number of frequencies not carrying services
    tE: the exploration time of a frequency carrying services
    t0: the exploration time of a frequency not carrying services
    tA: the analysis time of a frequency.

9.  Device (100) for automatically producing a service plan said device including a plurality (130.X) of receivers and recording the service plan produced in a configuration memory, the production device including means for processing (110) and for memorising (120), said means being suitable for:

    - distributing (1020) receivers of the plurality of receivers into two groups, with each group dedicated to one task:

        - a first group of receivers is dedicated to an exploration task of a frequency band to be explored, a band of which the lower limit and the upper limit are known, an exploration task instance supplies a list of frequencies carrying services, the exploration task instances are synchronised (2010) via a first semaphore protecting a value of the next frequency to be explored, an exploration task instance stops if the value of the next frequency to be explored is greater than the upper limit of the frequency band to be explored;
        - a second group of receivers is dedicated to an analysis task of the frequencies of the list of frequencies carrying services, an analysis task instance supplies a table of services, the analysis task instances are synchronised via a second semaphore protecting an identifier of a next frequency to be analysed, an analysis task instance stops if the list of frequencies carrying services is empty and if the value of the next frequency to be explored is greater than the upper limit of the frequency band;

- creating (1030; 1040) task instances according to the distribution of the receivers, with each receiver distributed being associated with a task according to the group thereof, the task instances are executed in parallel;
- making available (1060) of the table of services produced for the updating of the configuration memory.

10. Device according to claim 9, wherein there is a decoder box.

11. Non-volatile memory device comprising instruction codes for the implementation of a method according to one of claims 1 to 8.

12. Computer program product comprising instructions that when the program is executed by a computer, lead the latter to implement the steps of the method according to claims 1 to 8.

**Fig. 1**

**Fig. 2**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2003333441 A
- EP 1838096 A2
- WO 2009018766 A1